# EUROPEAN PATENT APPLICATION

(11) **EP 4 513 622 A1**
(43) Date of publication of application: **26.02.2025**
(21) Application number: 24195284.5
(22) Date of filing: 20.08.2024
(51) Int. Cl.: H01M 10/613, H01M 10/627, H01M 10/63, H01M 10/6567, H01M 10/6568

(54) **ENERGY STORAGE APPARATUS AND PHOTOVOLTAIC ENERGY STORAGE SYSTEM**

(30) Priority: 25.08.2023 CN 202311095400
(71) Applicant: Huawei Digital Power Technologies Co., Ltd., Shenzhen, Guangdong 518043 (CN)
(72) Inventor: LI, Zhaohui, Shenzhen, 518043 (CN); LI, Malin, Shenzhen, 518043 (CN); LIU, Huan, Shenzhen, 518043 (CN)
(74) Representative: Gill Jennings & Every LLP

(57) **Abstract**

An energy storage apparatus and a photovoltaic energy storage system are disclosed. The energy storage apparatus includes a heat exchange module, a liquid cooling module, a first heat dissipation module, a second heat dissipation module, and a load. The liquid cooling module performs heat exchange with the load. A housing of the heat exchange module has two cooling interfaces, two first liquid cooling interfaces, and two second liquid cooling interfaces. A heat exchanger and a multi-port valve are disposed inside the heat exchange module. The heat exchanger is connected to the two first liquid cooling interfaces and the two cooling interfaces. The multi-port valve is connected between the heat exchanger and one first liquid cooling interface, the multi-port valve is connected to one second liquid cooling interface, and the other second liquid cooling interface is connected to the other first liquid cooling interface. The liquid cooling module is connected between the two first liquid cooling interfaces, the first heat dissipation module is connected between the two cooling interfaces, and the second heat dissipation module is connected between the two second liquid cooling interfaces. In the foregoing solution, heat exchange density is high, energy consumption is low, a quantity of modularized interfaces is small, a leakage failure rate is low, and space utilization is high.

## Description

### TECHNICAL FIELD

This application relates to the energy field, and in particular, to an energy storage apparatus and a photovoltaic energy storage system.

### BACKGROUND

With continuous development and wide application of clean energy, energy storage devices that can store electric energy start to be widely used in a plurality of fields. Currently, there are more cabinet-level or container-level energy storage devices, to accommodate more batteries, thereby increasing power density of the energy storage devices and improving electric energy storage capabilities of the energy storage devices.

In the energy storage device, a plurality of batteries of the energy storage device are connected in series and in parallel, and are disposed in a box of the energy storage device, so that the box effectively protects the batteries. During actual use, the batteries generate heat during charging and discharging. Therefore, it needs to be ensured that the batteries are in a normal temperature range, so as to ensure charging and discharging performance and use safety of the batteries. Based on this, a heat dissipation system is usually disposed for the batteries in the energy storage device, to regulate temperatures of the batteries. However, for a heat dissipation system in which a conventional air cooling manner is used, cooling density of the heat dissipation system is limited by the cooling manner, and temperature regulation efficiency is low, which cannot meet a temperature regulation efficiency requirement of the current energy storage device.

### SUMMARY

This application provides an energy storage apparatus and a photovoltaic energy storage system, to improve temperature regulation efficiency of an energy storage device.

According to a first aspect, this application provides an energy storage apparatus. The energy storage apparatus may include a heat exchange module, a liquid cooling module, a first heat dissipation module, a second heat dissipation module, and a load. The liquid cooling module is configured to perform heat exchange with the load. A housing of the heat exchange module has two cooling interfaces, two first liquid cooling interfaces, and two second liquid cooling interfaces; a heat exchanger and a multi-port valve are disposed inside the heat exchange module; the heat exchanger is connected to the two first liquid cooling interfaces and the two cooling interfaces, and the heat exchanger may implement heat exchange between the first heat dissipation module and the liquid cooling module; and the multi-port valve is connected between the heat exchanger and one first liquid cooling interface, the multi-port valve is connected to one second liquid cooling interface, the multi-port valve may connect or disconnect the first heat dissipation module to or from the liquid cooling module, the multi-port valve may further connect or disconnect the second heat dissipation module to or from the liquid cooling module, and the other second liquid cooling interface is connected to the other first liquid cooling interface. The liquid cooling module may be connected between the two first liquid cooling interfaces, the first heat dissipation module may be connected between the two cooling interfaces, and the second heat dissipation module may be connected between the two second liquid cooling interfaces.

In the technical solution provided in this application, temperature regulation is performed on the load in a liquid cooling manner. For example, the first heat dissipation module may perform heat exchange with the liquid cooling module by using the heat exchange module, to implement temperature regulation on the load. The second heat dissipation module may directly perform heat exchange with the liquid cooling module, to implement temperature regulation on the load. Compared with an air cooling manner, the liquid cooling manner has higher heat exchange density, higher temperature regulation efficiency for the load, and lower energy consumption. In addition, in the energy storage apparatus provided in this application, components of functions such as heat dissipation, heat exchange, and liquid cooling are modularized, an overall quantity of interfaces is small, a leakage failure rate is low, and space utilization is high. In addition, the energy storage apparatus provided in this application controls the multi-port valve, so that temperature regulation can be performed on the load by using only the first heat dissipation module, or temperature regulation can be performed on the load by using only the second heat dissipation module, or temperature regulation can be performed on the load by using both the first heat dissipation module and the second heat dissipation module. Temperature regulation is flexible, regulation effect is ideal, and energy consumption can be effectively reduced.

In a specific feasible solution, a housing of the first heat dissipation module has two first heat dissipation interfaces, and the two first heat dissipation interfaces are respectively connected to the two cooling interfaces. A cooler is disposed inside the first heat dissipation module, and the cooler is separately connected to the two first heat dissipation interfaces, so that the cooler is connected to the cooling interface of the heat exchange module.

In a specific feasible solution, a housing of the second heat dissipation module has two second heat dissipation interfaces, and the two second heat dissipation interfaces are respectively connected to the two second liquid cooling interfaces. A first heat sink is disposed inside the second heat dissipation module, and the first heat sink is separately connected to the two second heat dissipation interfaces, so that the first heat sink is connected to the second liquid cooling interface of the heat exchange module.

In a specific feasible solution, the first heat dissipation module and the second heat dissipation module may be integrated, so that system integration can be further improved, and space utilization can be improved.

In a specific feasible solution, a first fan configured to dissipate heat may be disposed inside the first heat dissipation module, and the second heat dissipation module and the first heat dissipation module may share the first fan, so that a structure can be simplified, and costs can be reduced.

In a specific feasible solution, the energy storage apparatus may further include a heat-generating module. The housing of the heat exchange module may have two heat-generating interfaces, the heat exchanger may be connected to the two first liquid cooling interfaces, the two cooling interfaces, and the two heat-generating interfaces, and the heat exchanger is configured to perform heat exchange between the heat-generating module and the liquid cooling module. The heat-generating module is connected between the two heat-generating interfaces, so that the load is heated.

In a specific feasible solution, a housing of the heat-generating module has two heating interfaces, and the two heating interfaces are respectively connected to the two heat-generating interfaces. A second heat sink is disposed inside the heat-generating module, and the second heat sink is separately connected to the two heating interfaces, so that the second heat sink is connected to the heat-generating interface of the heat exchange module.

According to a second aspect, this application provides an energy storage apparatus. The energy storage apparatus may include a heat exchange module, a liquid cooling module, a first heat dissipation module, a second heat dissipation module, and a load. The liquid cooling module is configured to perform heat exchange with the load. A housing of the heat exchange module may have two cooling interfaces and two first liquid cooling interfaces; and a heat exchanger may be disposed inside the heat exchange module, the heat exchanger is connected to the two first liquid cooling interfaces and the two cooling interfaces, and the heat exchanger may implement heat exchange between the first heat dissipation module and the liquid cooling module. The liquid cooling module may be connected between the two first liquid cooling interfaces, the first heat dissipation module may be connected between the two cooling interfaces, and the second heat dissipation module may be connected between the liquid cooling module and one first liquid cooling interface.

In the technical solution provided in this application, temperature regulation is performed on the load in a liquid cooling manner. For example, the first heat dissipation module may perform heat exchange with the liquid cooling module by using the heat exchange module, to implement temperature regulation on the load. The second heat dissipation module may directly perform heat exchange with the liquid cooling module, to implement temperature regulation on the load. Therefore, a system has higher heat exchange density, higher temperature regulation efficiency for the load, and lower energy consumption. In addition, components are modularized, an overall quantity of interfaces in the system is small, a leakage failure rate is low, and space utilization is high. In addition, temperature regulation can be performed on the load by using only the second heat dissipation module alone, or temperature regulation may be performed on the load by using both the first heat dissipation module and the second heat dissipation module. Temperature regulation is flexible, regulation effect is ideal, and energy consumption can be effectively reduced.

In a specific feasible solution, a housing of the first heat dissipation module has two first heat dissipation interfaces, and the two first heat dissipation interfaces are respectively connected to the two cooling interfaces. A cooler is disposed inside the first heat dissipation module, and the cooler is separately connected to the two first heat dissipation interfaces, so that the cooler is connected to the cooling interface of the heat exchange module.

In a specific feasible solution, a housing of the second heat dissipation module has two second heat dissipation interfaces, and the two second heat dissipation interfaces are respectively connected to the liquid cooling module and one first liquid cooling interface. A first heat sink is disposed inside the second heat dissipation module, and the first heat sink is separately connected to the two second heat dissipation interfaces, so that the first heat sink is connected between the liquid cooling module and the heat exchange module.

In a specific feasible solution, a first fan configured to dissipate heat may be disposed inside the first heat dissipation module, and a second fan configured to dissipate heat may be disposed inside the second heat dissipation module. The first heat dissipation module and the second heat dissipation module each use one fan. Air resistance of each fan is small, and power consumption of the first heat dissipation module and the second heat dissipation module is small.

In a specific feasible solution, the energy storage apparatus may further include a compressor module, and the compressor module is connected between one first heat dissipation interface and one cooling interface. A compressor and a gas-liquid separator that are separately connected to the first heat dissipation module and the heat exchange module in sequence may be disposed inside the compressor module. The compressor may increase a refrigerant from a low pressure to a high pressure, and enable the refrigerant to continuously flow in circulation, thereby discharging heat of the heat exchange module to an external environment. The gas-liquid separator may filter and remove some moisture from the refrigerant, to reduce a workload of the compressor.

In a specific feasible solution, a heater may be disposed inside the heat exchange module, and the heater is connected between the heat exchanger and one first liquid cooling interface, so that the load is heated.

In a specific feasible solution, a housing of the liquid cooling module has two heat exchange interfaces, and the two heat exchange interfaces are respectively connected to the two first liquid cooling interfaces. A cold plate is disposed inside the liquid cooling module, the cold plate is configured to perform heat exchange with the load, and the cold plate is separately connected to the two heat exchange interfaces, so that the liquid cooling module performs heat exchange with the load.

According to a third aspect, this application further provides a photovoltaic energy storage system. The photovoltaic energy storage system may include a power generation device, a power conversion device, and the energy storage apparatus in any one of the feasible solutions of the first aspect or the second aspect. The power conversion device is connected between the power generation device and the energy storage apparatus, and the power generation device is configured to store generated electric energy into the load of the energy storage apparatus by using the power conversion device. The photovoltaic energy storage system has high power density, high working stability, and high use safety.

### BRIEF DESCRIPTION OF DRAWINGS

FIG. 1 is a diagram of a structure of an energy storage apparatus according to this application;
FIG. 2 is a diagram of a structure of a liquid cooling module of an energy storage apparatus according to this application;
FIG. 3 is a diagram of another structure of a liquid cooling module of an energy storage apparatus according to this application;
FIG. 4 is a diagram of another structure of an energy storage apparatus according to this application;
FIG. 5 is a diagram of another structure of an energy storage apparatus according to this application; and
FIG. 6 is a diagram of a possible structure of a photovoltaic energy storage system according to this application.

### Reference numerals:

100: heat exchange module; 200: liquid cooling module; 300: first heat dissipation module; 400: second heat dissipation module;
500: compressor module; 600: heat-generating module; 101: cooling interface; 102: first liquid cooling interface;
103: second liquid cooling interface; 104: heat exchanger; 105: multi-port valve; 106: refrigerant pipeline;
107: first coolant pipeline; 108: second coolant pipeline; 109: first pump body; 110: electronic expansion valve;
111: heater; 112: heat-generating interface; 113: heat-generating pipeline; 201: heat exchange interface;
202: cold plate; 203: load; 301: first heat dissipation interface; 302: cooler;
303: first fan; 401: second heat dissipation interface; 402: first heat sink; 403: second fan;
501: compression interface; 502: compressor; 503: gas-liquid separator; 601: heating interface;
602: second heat sink; 603: second pump body; 604: third fan; 1: energy storage device;
2: power conversion device; 3: power generation device.

### DESCRIPTION OF EMBODIMENTS

To make the objectives, technical solutions, and advantages of this application clearer, the following further describes embodiments of this application in detail with reference to the accompanying drawings. However, example implementations can be implemented in a plurality of forms, and should not be construed as being limited to the implementations described herein. Same reference numerals in the accompanying drawings represent same or similar structures, and repeated descriptions thereof are omitted. Words for expressing positions and directions in embodiments of this application are described by using the accompanying drawings as examples. However, changes may be made as required, and all changes shall fall within the protection scope of this application. The accompanying drawings in embodiments of this application are merely used to show a relative position relationship, and do not represent an actual scale.

Specific details are described in the following description to facilitate understanding of this application. However, embodiments of this application may be implemented in a plurality of other manners different from those described herein, and a person skilled in the art may make similar promotion without departing from the connotation of embodiments of this application. Therefore, this application is not limited to the following disclosed specific implementations.

For ease of understanding, an application scenario of an energy storage apparatus in this application is first described. The energy storage apparatus provided in embodiments of this application may be but is not limited to an industrial and commercial energy storage scenario such as a small industrial and commercial industry (for example, a small factory), a medium industrial and commercial industry, a large industrial and commercial industry, a photovoltaic energy storage charging station, and a small and medium-sized microgrid (for example, an island), and a power station scenario such as a photovoltaic-wind energy storage station, a power grid energy storage station, and a large micro grid, to store and release electric energy. During actual application, the energy storage apparatus may be embodied in a form of an energy storage cabinet, an energy storage container, or the like. In a related technology, the energy storage device uses a conventional air cooling heat dissipation system, and temperature regulation efficiency of the conventional air cooling heat dissipation system is low, which cannot meet a temperature regulation efficiency requirement of the energy storage device with high power density. Based on this, embodiments of this application provide an energy storage apparatus, to improve temperature regulation efficiency of an energy storage device.

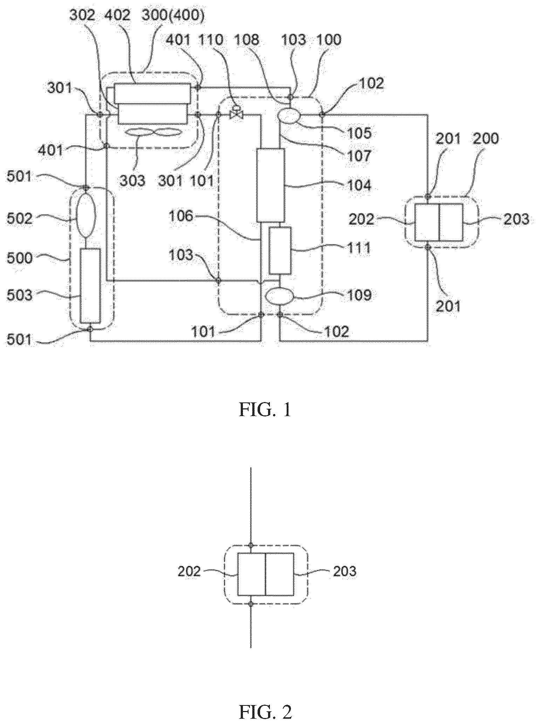

Refer to FIG. 1 first. FIG. 1 is a diagram of a structure of the energy storage apparatus according to this application. As shown in FIG. 1, embodiments of this application provide the energy storage apparatus. The energy storage apparatus includes a heat exchange module 100, a liquid cooling module 200, a first heat dissipation module 300, a second heat dissipation module 400, and a load 203. The liquid cooling module 200 may perform heat exchange with the load 203 such as a battery, to perform temperature regulation on the load 203. During actual application, the liquid cooling module 200 may perform heat exchange with a single cell, or may perform heat exchange with a battery module, or may perform heat exchange with a battery pack (pack).

In specific implementation, a housing of the heat exchange module 100 may have two cooling interfaces 101, two first liquid cooling interfaces 102, and two second liquid cooling interfaces 103, and a heat exchanger 104 and a multi-port valve 105 may be disposed inside the heat exchange module 100. The heat exchanger 104 is connected to the two first liquid cooling interfaces 102 and the two cooling interfaces 101, and the heat exchanger 104 may implement heat exchange between the first heat dissipation module 300 and the liquid cooling module 200. The multi-port valve 105 is connected between the heat exchanger 104 and one first liquid cooling interface 102, and the multi-port valve 105 is connected to one second liquid cooling interface 103. The multi-port valve 105 may connect or disconnect the first heat dissipation module 300 to or from the liquid cooling module 200, and the multi-port valve 105 may further connect or disconnect the second heat dissipation module 400 to or from the liquid cooling module 200. Specifically, the multi-port valve 105 may connect or disconnect the heat exchanger 104 to or from one first liquid cooling interface 102, to connect or disconnect the first heat dissipation module 300 to or from the liquid cooling module 200. The multi-port valve 105 may connect or disconnect one second liquid cooling interface 103 to or from one first liquid cooling interface 102, to connect or disconnect the second heat dissipation module 400 to or from the liquid cooling module 200. The other second liquid cooling interface 103 is connected to the other first liquid cooling interface 102.

Specifically, a refrigerant pipeline 106, a first coolant pipeline 107, and a second coolant pipeline 108 may be further disposed inside the heat exchange module 100. During actual application, a refrigerant such as freon or ammonia may flow in the refrigerant pipeline 106, and a coolant such as glycol, glycol solution, or water may flow in the first coolant pipeline 107 and the second coolant pipeline 108. The following first describes specific connection relationships between the interfaces of the housing and various components and pipelines inside the heat exchange module 100.

Two ends of the refrigerant pipeline 106 are respectively connected to the two cooling interfaces 101. Two ends of the first coolant pipeline 107 are respectively connected to the two first liquid cooling interfaces 102. Two ends of the second coolant pipeline 108 are respectively connected to the two second liquid cooling interfaces 103, and a part of the first coolant pipeline 107 is connected in the second coolant pipeline 108, which may be understood as that the first coolant pipeline 107 and the second coolant pipeline 108 have a shared pipeline.

The heat exchanger 104 is connected in the refrigerant pipeline 106 and the first coolant pipeline 107. The heat exchanger 104 may implement heat exchange between a refrigerant in the refrigerant pipeline 106 and a coolant in the first coolant pipeline 107. From a perspective of a module, the heat exchanger 104 may implement heat exchange between the first heat dissipation module 300 and the liquid cooling module 200.

The multi-port valve 105 is connected in the first coolant pipeline 107, and the multi-port valve 105 is connected to a joint between the first coolant pipeline 107 and the second coolant pipeline 108. The multi-port valve 105 is controlled, so that the first coolant pipeline 107 may be connected or disconnected, and the second coolant pipeline 108 may be connected to or disconnected from the first coolant pipeline 107.

In specific implementation, the liquid cooling module 200 is connected between the two first liquid cooling interfaces 102, and the load 203 (for example, the battery) may be integrated into the liquid cooling module 200. The first heat dissipation module 300 is connected between the two cooling interfaces 101, to implement compression cooling. The second heat dissipation module 400 is connected between the two second liquid cooling interfaces 103 to implement natural cooling.

In the energy storage apparatus provided in embodiments of this application, temperature regulation is performed on the load 203 in a liquid cooling manner. Specifically, the first heat dissipation module 300 may perform heat exchange with the liquid cooling module 200 by using the heat exchange module 100, to implement temperature regulation on the load 203. The second heat dissipation module 400 may directly perform heat exchange with the liquid cooling module 200, to implement temperature regulation on the load 203. Compared with an air cooling manner, the liquid cooling manner has higher heat exchange density, higher temperature regulation efficiency for the load 203, and lower energy consumption. In addition, in the energy storage apparatus provided in embodiments of this application, components of functions such as heat dissipation, heat exchange, and liquid cooling are modularized, an overall quantity of interfaces is small, a leakage failure rate is low, and space utilization is high. In addition, the energy storage apparatus provided in embodiments of this application controls the multi-port valve 105, so that temperature regulation can be performed on the load 203 by using only the first heat dissipation module 300, or temperature regulation can be performed on the load 203 by using only the second heat dissipation module 400, or temperature regulation can be performed on the load 203 by using both the first heat dissipation module 300 and the second heat dissipation module 400. Temperature regulation is flexible, regulation effect is ideal, and energy consumption can be effectively reduced. For example, when an ambient temperature is high (for example, when the ambient temperature> 10°C), temperature regulation may be performed on the load 203 by using only the first heat dissipation module 300; and when the ambient temperature is low (for example, when the ambient temperature≤10°C), temperature regulation may be performed on the load 203 by using only the second heat dissipation module 400, so that energy efficiency is high and more energy can be saved. In addition, when the ambient temperature is high (for example, when 10°C<the ambient temperature<25°C), temperature regulation may be performed on the load 203 by using both the first heat dissipation module 300 and the second heat dissipation module 400, to reduce energy consumption of the first heat dissipation module 300.

In specific implementation, a first pump body 109 may be further disposed inside the heat exchange module 100. The first pump body 109 is connected in the first coolant pipeline 107. The first pump body 109 is configured to increase a coolant flow rate in the first coolant pipeline 107, so as to improve heat exchange efficiency of the liquid cooling module 200 for the load 203. Specifically, heat dissipation efficiency for the load 203 may be improved. An electronic expansion valve 110 may be further disposed inside the heat exchange module 100. The electronic expansion valve 110 is connected to the refrigerant pipeline 106. The electronic expansion valve 110 may adjust a liquid supply amount. Specifically, the electronic expansion valve 110 may adjust a flow volume of a refrigerant provided by the first heat dissipation module 300 to the heat exchange module 100.

In a possible implementation, a housing of the first heat dissipation module 300 may have two first heat dissipation interfaces 301. During specific connection, the two first heat dissipation interfaces 301 are respectively connected to the two cooling interfaces 101, to implement connection between the first heat dissipation module 300 and the heat exchange module 100. A cooler 302 may be disposed inside the first heat dissipation module 300. The cooler 302 is separately connected to the two first heat dissipation interfaces 301, to implement connection between the cooler 302 and the heat exchange module 100, and further implement connection between the cooler 302 and the refrigerant pipeline 106. The cooler 302 may cool the refrigerant, so as to implement heat exchange between the refrigerant in the refrigerant pipeline 106 and the coolant in the first coolant pipeline 107 by using the heat exchanger 104. Specifically, the cooler 302 may be a refrigerant condenser.

In specific implementation, the energy storage apparatus provided in embodiments of this application may further include a compressor module 500. The compressor module 500 is connected between one first heat dissipation interface 301 and one cooling interface 101, so that the compressor module 500 is connected between the first heat dissipation module 300 and the heat exchange module 100. A compressor 502 and a gas-liquid separator 503 that are separately connected to the first heat dissipation module 300 and the heat exchange module 100 in sequence may be disposed inside the compressor module 500. The compressor 502 may increase the refrigerant from a low pressure to a high pressure, and enable the refrigerant to continuously flow in circulation, thereby discharging heat of the heat exchange module 100 to an external environment. The gas-liquid separator 503 may filter and remove some moisture from the refrigerant, to reduce a workload of the compressor 502.

A housing of the compressor module 500 may have two compression interfaces 501. During specific connection, the two compression interfaces 501 are respectively connected to one first heat dissipation interface 301 and one cooling interface 101. Inside the compressor module 500, the compressor 502 and the gas-liquid separator 503 are separately connected to one compression interface 501. In specific implementation, the compressor module 500 and the first heat dissipation module 300 may be integrated.

In a possible implementation, a housing of the second heat dissipation module 400 may have two second heat dissipation interfaces 401, and the two second heat dissipation interfaces 401 are respectively connected to the two second liquid cooling interfaces 103, to implement connection between the second heat dissipation module 400 and the heat exchange module 100. A first heat sink 402 may be disposed inside the second heat dissipation module 400, and the first heat sink 402 is separately connected to the two second heat dissipation interfaces 401, to implement connection between the first heat sink 402 and the heat exchange module 100, thereby implementing connection between the first heat sink 402 and the second coolant pipeline 108. Specifically, the first heat sink 402 may be a natural cooling heat sink.

In specific implementation, the first heat dissipation module 300 and the second heat dissipation module 400 may be integrated, so that integration can be further improved, and space utilization can be improved. As shown in FIG. 1, a first fan 303 configured to dissipate heat may be disposed inside the first heat dissipation module 300, and the second heat dissipation module 400 and the first heat dissipation module 300 may share the first fan 303. Specifically, the first heat sink 402 and the cooler 302 may share one first fan 303. Alternatively, a first fan 303 may be disposed inside the first heat dissipation module 300, and a first fan 303 may also be disposed inside the second heat dissipation module 400. The first heat sink 402 and the cooler 302 each may use one first fan 303.

In a possible implementation, a housing of the liquid cooling module 200 may have two heat exchange interfaces 201. During specific connection, the two heat exchange interfaces 201 are respectively connected to the two first liquid cooling interfaces 102. A cold plate 202 may be disposed inside the liquid cooling module 200, and the cold plate 202 is separately connected to the two heat exchange interfaces 201. The coolant flows through the cold plate 202, and the cold plate 202 may perform heat exchange with the load 203. Specifically, the coolant fully performs heat exchange with the load 203 by using the cold plate 202, thereby improving heat exchange efficiency.

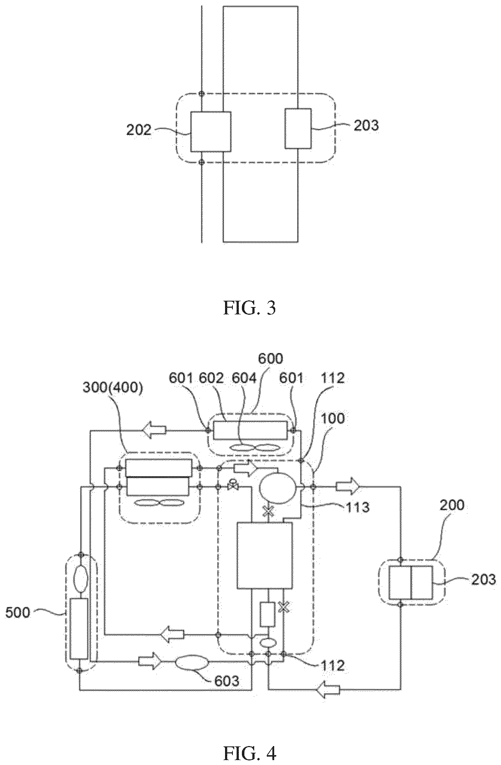

FIG. 2 is a diagram of a structure of the liquid cooling module of the energy storage apparatus according to this application. FIG. 3 is a diagram of another structure of the liquid cooling module of the energy storage apparatus according to this application. In specific implementation, as shown in FIG. 2, the cold plate 202 may directly contact the load 203 to implement heat exchange, or the cold plate 202 may be connected to the load 203 by using a heat-conducting adhesive or the like to implement heat exchange. Alternatively, as shown in FIG. 3, the cold plate 202 may be replaced with another type of heat exchanger such as an immersion heat exchanger. During actual application, the cold plate 202 may be immersed in heat-conducting liquid inside the load 203, or the cold plate 202 and the load 203 are immersed in the heat-conducting liquid at the same time to implement heat exchange. During actual provision, a cavity or a runner may be provided inside the cold plate 202, and the coolant flows through the cavity or the runner, to implement heat exchange with the cold plate 202, thereby implementing heat exchange with the load 203.

In a possible implementation, a heater 111 may be further disposed inside the heat exchange module 100, and the heater 111 is connected between the heat exchanger 104 and one first liquid cooling interface 102. Specifically, the heater 111 is connected in the first coolant pipeline 107, and the heater 111 may heat the coolant in the first coolant pipeline 107, so as to perform heat exchange on the load 203. Specifically, the load 203 is heated. In specific implementation, the heater 111 may be an electric heater 111 suitable for heating the coolant. For example, the heater 111 may use a positive temperature coefficient (positive temperature coefficient, PTC) thermistor, which is also referred to as a PTC thermistor or PTC. When the ambient temperature is low, for example, in winter, the load 203 such as the battery needs to be heated, so as to stabilize a temperature of the load 203 in a normal temperature range (for example, around 25°C) before the load 203 is charged and discharged, thereby ensuring charging and discharging performance and use safety of the load 203, and ensuring an optimal service life of the load 203.

FIG. 4 is a diagram of another structure of the energy storage apparatus according to this application. In addition to the manner, in the foregoing embodiment, in which the heater 111 is used to heat the load 203, the load 203 may be heated in another manner. For example, as shown in FIG. 4, the energy storage apparatus provided in embodiments of this application may further include a heat-generating module 600. The housing of the heat exchange module 100 may have two heat-generating interfaces 112, and the heat exchanger 104 is connected to the two first liquid cooling interfaces 102, the two cooling interfaces 101, and the two heat-generating interfaces 112. Specifically, a heat-generating pipeline 113 may be disposed inside the heat exchange module 100, and the heat-generating pipeline 113 may allow flow of the refrigerant. The heat-generating pipeline 113 is separately connected to the two heat-generating interfaces 112, and the heat exchanger 104 is connected in the heat-generating pipeline 113, the refrigerant pipeline 106, and the first coolant pipeline 107. Heat exchange between the heat-generating module 600 and the liquid cooling module 200 is implemented by using the heat exchanger 104.

In specific implementation, the heat-generating module 600 is connected between the two heat-generating interfaces 112. A housing of the heat-generating module 600 has two heating interfaces 601. During specific connection, the two heating interfaces 601 are respectively connected to the two heat-generating interfaces 112. A second heat sink 602 may be disposed inside the heat-generating module 600, and the second heat sink 602 is separately connected to the two heating interfaces 601. The second heat sink 602 may absorb external heat, and heat the refrigerant in the heat-generating pipeline 113, so as to implement heat exchange between the refrigerant in the heat-generating pipeline 113 and the coolant in the first coolant pipeline 107 by using the heat exchanger 104, and specifically, implement heating for the load 203. The second heat sink 602 may be a heat sink that is suitable for heating a refrigerant, such as an evaporator. During actual application, the load 203 may be heated by using both the heater 111 and the heat-generating module 600.

In specific implementation, a second pump body 603 may be further disposed inside the heat-generating module 600, and the second pump body 603 is connected in the heat-generating pipeline 113. The second pump body 603 may increase a flow rate of the refrigerant in the heat-generating pipeline 113, so as to improve heat exchange efficiency between the refrigerant in the heat-generating pipeline 113 and the coolant in the first coolant pipeline 107, and specifically, improve efficiency of heating the load 203. Alternatively, as shown in FIG. 4, the second pump body 603 may be disposed outside the heat-generating module 600. For example, the second pump body 603 may be connected between the heat-generating module 600 and the heat exchange module 100. In addition, a third fan 604 may be further disposed inside the heat-generating module 600. The third fan 604 may accelerate air convection inside the heat-generating module 600, improve heat exchange efficiency between the second heat sink 602 and the load 203, and specifically, improve efficiency of heating the load 203 by the second heat sink 602.

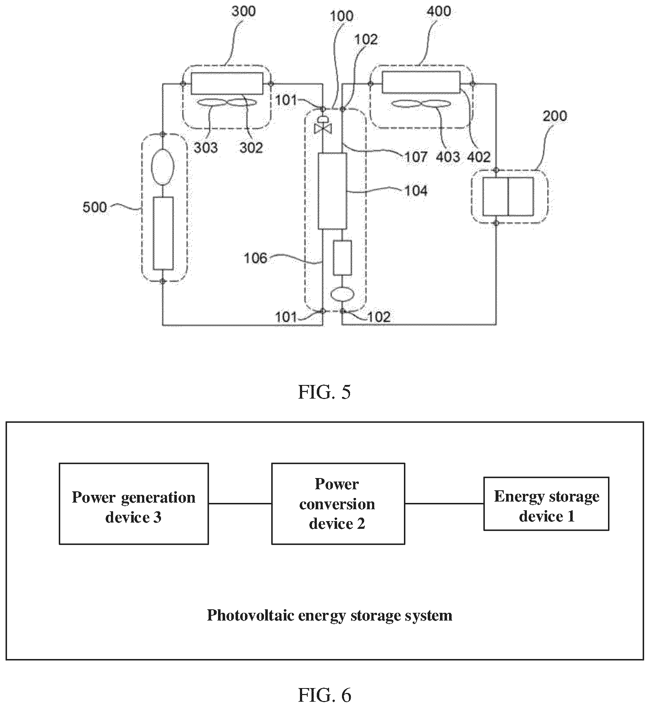

FIG. 5 is a diagram of another structure of an energy storage apparatus according to this application. For some reference numerals in FIG. 5, refer to the same reference numerals in FIG. 1. As shown in FIG. 5, embodiments of this application further provide another energy storage apparatus. Different from the foregoing embodiment, a housing of a heat exchange module 100 of the energy storage apparatus may have two cooling interfaces 101 and two first liquid cooling interfaces 102. A heat exchanger 104 may be disposed inside the heat exchange module 100, and the heat exchanger 104 is connected to the two first liquid cooling interfaces 102 and the two cooling interfaces 101. Specifically, a refrigerant pipeline 106 and a first coolant pipeline 107 may be disposed inside the heat exchange module 100. The refrigerant pipeline 106 is separately connected to the two cooling interfaces 101. The first coolant pipeline 107 is separately connected to the two first liquid cooling interfaces 102. The heat exchanger 104 is connected in the refrigerant pipeline 106 and the first coolant pipeline 107, and the heat exchanger 104 may implement heat exchange between a first heat dissipation module 300 and a liquid cooling module 200. In specific implementation, the liquid cooling module 200 is connected between the two first liquid cooling interfaces 102. The first heat dissipation module 300 is connected between the two cooling interfaces 101. The second heat dissipation module 400 is connected between the liquid cooling module 200 and one first liquid cooling interface 102.

In specific implementation, a housing of the first heat dissipation module 300 has two first heat dissipation interfaces 301. During specific connection, the two first heat dissipation interfaces 301 are respectively connected to the two cooling interfaces 101, to implement connection between the first heat dissipation module 300 and the heat exchange module 100. A cooler 302 is disposed inside the first heat dissipation module 300, and the cooler 302 is separately connected to the two first heat dissipation interfaces 301. The cooler 302 may cool a refrigerant. The energy storage apparatus may further include a compressor module 500. The compressor module 500 is connected between one first heat dissipation interface 301 and one cooling interface 101, so that the compressor module 500 is connected between the first heat dissipation module 300 and the heat exchange module 100. A compressor 502 and a gas-liquid separator 503 that are separately connected to the first heat dissipation module 300 and the heat exchange module 100 in sequence may be disposed inside the compressor module 500. The compressor 502 may increase the refrigerant from a low pressure to a high pressure, and enable the refrigerant to continuously flow in circulation, thereby discharging heat of the heat exchange module 100 to an external environment. The gas-liquid separator 503 may filter and remove some moisture from the refrigerant, to reduce a workload of the compressor 502.

A housing of the second heat dissipation module 400 has two second heat dissipation interfaces 401, and the two second heat dissipation interfaces 401 are respectively connected to the liquid cooling module 200 and one first liquid cooling interface 102, to implement connection between the second heat dissipation module 400 and the heat exchange module 100. A first heat sink 402 is disposed inside the second heat dissipation module 400, and the first heat sink 402 is separately connected to the two second heat dissipation interfaces 401, to implement connection between the first heat sink 402 and the heat exchange module 100, thereby implementing connection between the first heat sink 402 and a second coolant pipeline 108.

In a possible implementation, a first fan 303 configured to dissipate heat may be disposed inside the first heat dissipation module 300, and a second fan 403 configured to dissipate heat may be disposed inside the second heat dissipation module 400. That is, the cooler 302 and the first heat sink 402 each may use one fan.

In specific implementation, the energy storage apparatus may include a cabinet body. In this case, the energy storage apparatus may be referred to as an energy storage cabinet. For reference, the first heat dissipation module 300 and the second heat dissipation module 400 may be disposed outside the cabinet body, and a remaining part of the energy storage apparatus may be disposed inside the cabinet body. A load 203 is disposed inside the liquid cooling module 200. During actual application, in addition to a form of a cabinet body, a container may alternatively be used. In this case, the energy storage apparatus may be referred to as an energy storage container.

The energy storage device provided in the foregoing embodiment of this application may be used in various energy storage scenarios. As shown in FIG. 6, FIG. 6 is a diagram of a possible structure of a photovoltaic energy storage system according to this application. The photovoltaic energy storage system may include a power conversion device 2, a power generation device 3, and the foregoing energy storage device 1. The power conversion device 2 is connected between the power generation device 3 and the energy storage device 1. During actual application, the power generation device 3 stores generated electric energy into the load of the energy storage device 1 by using the power conversion device 2. The photovoltaic energy storage system is applied to the energy storage device 1 provided in the foregoing embodiment, so that running security of the photovoltaic energy storage system can be effectively improved.

It may be understood that various numbers in embodiments of this application are merely used for differentiation for ease of description, and are not used to limit the scope of embodiments of this application. Sequence numbers of the foregoing processes do not mean execution sequences, and the execution sequences of the processes should be determined based on functions and internal logic of the processes.

The foregoing descriptions are merely specific implementations of this application, but are not intended to limit the protection scope of this application. Any variation or replacement readily figured out by a person skilled in the art within the technical scope disclosed in this application shall fall within the protection scope of this application.

## Claims

1. An energy storage apparatus, comprising a heat exchange module, a liquid cooling module, a first heat dissipation module, a second heat dissipation module, and a load, wherein the liquid cooling module is configured to perform heat exchange with the load;
a housing of the heat exchange module has two cooling interfaces, two first liquid cooling interfaces, and two second liquid cooling interfaces; a heat exchanger and a multi-port valve are disposed inside the heat exchange module; the heat exchanger is connected to the two first liquid cooling interfaces and the two cooling interfaces, and the heat exchanger is configured to perform heat exchange between the first heat dissipation module and the liquid cooling module; and the multi-port valve is connected between the heat exchanger and one first liquid cooling interface, the multi-port valve is connected to one second liquid cooling interface, and the other second liquid cooling interface is connected to the other first liquid cooling interface; and
the liquid cooling module is connected between the two first liquid cooling interfaces, the first heat dissipation module is connected between the two cooling interfaces, and the second heat dissipation module is connected between the two second liquid cooling interfaces.

2. The energy storage apparatus according to claim 1, wherein a housing of the first heat dissipation module has two first heat dissipation interfaces, and the two first heat dissipation interfaces are respectively connected to the two cooling interfaces; and
a cooler is disposed inside the first heat dissipation module, and the cooler is separately connected to the two first heat dissipation interfaces.

3. The energy storage apparatus according to claim 1 or 2, wherein a housing of the second heat dissipation module has two second heat dissipation interfaces, and the two second heat dissipation interfaces are respectively connected to the two second liquid cooling interfaces; and
a first heat sink is disposed inside the second heat dissipation module, and the first heat sink is separately connected to the two second heat dissipation interfaces.

4. The energy storage apparatus according to any one of claims 1 to 3, wherein the first heat dissipation module and the second heat dissipation module are integrated.

5. The energy storage apparatus according to claim 4, wherein a first fan configured to dissipate heat is disposed inside the first heat dissipation module, and the second heat dissipation module and the first heat dissipation module share the first fan.

6. The energy storage apparatus according to any one of claims 1 to 5, wherein the liquid cooling system further comprises a heat-generating module;
the housing of the heat exchange module has two heat-generating interfaces, the heat exchanger is connected to the two first liquid cooling interfaces, the two cooling interfaces, and the two heat-generating interfaces, and the heat exchanger is configured to perform heat exchange between the heat-generating module and the liquid cooling module; and
the heat-generating module is connected between the two heat-generating interfaces.

7. The energy storage apparatus according to claim 6, wherein a housing of the heat-generating module has two heating interfaces, and the two heating interfaces are respectively connected to the two heat-generating interfaces; and
a second heat sink is disposed inside the heat-generating module, and the second heat sink is separately connected to the two heating interfaces.

8. An energy storage apparatus, comprising a heat exchange module, a liquid cooling module, a first heat dissipation module, a second heat dissipation module, and a load, wherein the liquid cooling module is configured to perform heat exchange with the load;
a housing of the heat exchange module has two cooling interfaces and two first liquid cooling interfaces; and a heat exchanger is disposed inside the heat exchange module, the heat exchanger is connected to the two first liquid cooling interfaces and the two cooling interfaces, and the heat exchanger is configured to perform heat exchange between the first heat dissipation module and the liquid cooling module; and
the liquid cooling module is connected between the two first liquid cooling interfaces, the first heat dissipation module is connected between the two cooling interfaces, and the second heat dissipation module is connected between the liquid cooling module and one first liquid cooling interface.

9. The energy storage apparatus according to claim 8, wherein a housing of the first heat dissipation module has two first heat dissipation interfaces, and the two first heat dissipation interfaces are respectively connected to the two cooling interfaces; and
a cooler is disposed inside the first heat dissipation module, and the cooler is separately connected to the two first heat dissipation interfaces.

10. The energy storage apparatus according to claim 8 or 9, wherein a housing of the second heat dissipation module has two second heat dissipation interfaces, and the two second heat dissipation interfaces are respectively connected to the liquid cooling module and one first liquid cooling interface; and
a first heat sink is disposed inside the second heat dissipation module, and the first heat sink is separately connected to the two second heat dissipation interfaces.

11. The energy storage apparatus according to any one of claims 8 to 10, wherein a first fan configured to dissipate heat is disposed inside the first heat dissipation module, and a second fan configured to dissipate heat is disposed inside the second heat dissipation module.

12. The energy storage apparatus according to any one of claims 1 to 11, wherein the liquid cooling system further comprises a compressor module, and the compressor module is connected between one first heat dissipation interface and one cooling interface; and
a compressor and a gas-liquid separator that are separately connected to the first heat dissipation module and the heat exchange module in sequence are disposed inside the compressor module.

13. The energy storage apparatus according to any one of claims 1 to 12, wherein a heater is disposed inside the heat exchange module, and the heater is connected between the heat exchanger and one first liquid cooling interface.

14. The energy storage apparatus according to any one of claims 1 to 13, wherein a housing of the liquid cooling module has two heat exchange interfaces, and the two heat exchange interfaces are respectively connected to the two first liquid cooling interfaces; and
a cold plate is disposed inside the liquid cooling module, the cold plate is configured to perform heat exchange with the load, and the cold plate is separately connected to the two heat exchange interfaces.

15. A photovoltaic energy storage system, comprising a power generation device, a power conversion device, and the energy storage apparatus according to any one of claims 1 to 14, wherein the power conversion device is connected between the power generation device and the energy storage apparatus, and the power generation device is configured to store generated electric energy into the load of the energy storage apparatus by using the power conversion device.
